# EUROPÄISCHE PATENTSCHRIFT

(11) **EP 1 891 723 B1**
(45) Veröffentlichungstag und Bekanntmachung des Hinweises auf die Patenterteilung: **21.11.2018**
(21) Anmeldenummer: 06753314.1
(22) Anmeldetag: 15.06.2006
(51) Int. Cl.: H02J 1/10, G01R 31/02

(54) **VERFAHREN ZUM BESTIMMEN EINER ZUSAMMENSCHALTUNGSART VON MINDESTENS ZWEI ELEKTRISCHEN EINRICHTUNGEN UND SYSTEM MIT MEHREREN ELEKTRISCHEN EINRICHTUNGEN**
METHOD FOR DETERMINING THE TYPE OF CONNECTION OF AT LEAST TWO ELECTRICAL DEVICES AND SYSTEM COMPRISING SEVERAL ELECTRIC DEVICES
PROCEDE POUR DETERMINER UN TYPE D'INTERCONNEXION D'AU MOINS DEUX DISPOSITIFS ELECTRIQUES ET SYSTEME COMPORTANT PLUSIEURS DISPOSITIFS ELECTRIQUES

(30) Priorität: 17.06.2005 DE 102005028513
(43) Veröffentlichungstag der Anmeldung: 27.02.2008
(73) Patentinhaber: SMA Solar Technology AG, 34266 Niestetal (DE)
(72) Erfinder: THORNGREEN, Thomas, Kure, DK-2630 Taastrup (DK); DOROFTE, Christinel, DK-6400 Sønderborg (DK); BORUP, Uffe, DK-6470 Sydals (DK)
(74) Vertreter: Lahnor, Peter
(86) Internationale Anmeldenummer: PCT/DK2006/000347
(87) Internationale Veröffentlichungsnummer: WO 2006/133714

(56) Entgegenhaltungen:
- EP-A- 1 030 429
- EP-A1- 0 690 542
- US-A- 6 157 308
- US-A1- 2004 039 536

## Beschreibung

Die Erfindung betrifft ein Verfahren zum Bestimmen einer Zusammenschaltungsart von mindestens zwei elektrischen Einrichtungen, von denen jede eine gleichartige Anschlußanordnung aufweist. Ferner betrifft die Erfindung ein System mit mehreren elektrischen Einrichtungen, von denen jede eine gleichartige Anschlußanordnung aufweist, und einer Steuereinrichtung.

Die Erfindung wird im folgenden anhand eines Systems beschrieben, bei dem mehrere Quellen von erneuerbarer Energie vorgesehen sind. Bei diesen Quellen handelt es sich um Einrichtungen, die Sonne, Wind, Wasserkraft oder andere natürlich vorkommende Energien in elektrische Energie umsetzen. Diese Energie wird auch als "grüne Energie" bezeichnet.

Die nachfolgende Beschreibung verwendet Solarzellen als Beispiel für die Erzeugung von grüner Energie. Solarzellen werden verwendet, um Sonnenlicht in elektrische Energie umzuwandeln. Solarzellen sind vielfach zu Paneelen zusammengefaßt, um eine höhere Spannung und auch Leistung zu erzeugen, als sie von einer einzelnen Solarzelle bereitgestellt werden könnte. Mehrere Paneele werden vielfach zu einem String in Reihe geschaltet.

Eine typische Fotovoltaikanlage verwendet einen Solarzellen-String, der eine wechselnde elektrische Leistung zur Verfügung stellt. Diese Leistung hängt beispielsweise von der Sonneneinstrahlung (morgens, mittags, abends), von der Abschattung und auch von der Umgebungstemperatur ab. Diese Leistung wird durch einen Gleichstromwandler in eine konstante Zwischenkreis-spannung umgewandelt. Eine Wechselrichterstufe erzeugt dann eine Wechselspannung, die entweder unmittelbar genutzt werden kann, beispielsweise in Haushaltsgeräten, oder die in ein übergeordnetes Netz eingespeist werden kann. Dabei kann es sich sowohl um eine Einphasen-Spannung handeln als auch um eine Mehrphasen-Spannung.

Bei einem höheren Leistungsbedarf ist es vorteilhaft, wenn man mehrere voneinander getrennte Solarzellen-Strings in einem System hat. Diese Strings könnten dann parallel zueinander mit dem Eingang des Gleichstromwandlers verbunden werden. Diese Solarzellen-Strings werden jedoch nur dann ein im wesentlichen gleiches Verhalten an ihren Ausgängen zeigen, wenn sie vom gleichen Typ sind, die gleiche Größe haben, die gleiche Ausrichtung in Bezug auf die Sonne und die gleiche Abschattung. Dementsprechend werden sich in vielen Fällen die Ausgangsleistungen, beispielsweise die Ausgangsspannung, voneinander unterscheiden. Dies führt dann zu einer nicht optimalen Verwendung der Solarzellen-Strings.

Man hat daher vorgeschlagen, die einzelnen Solarzellen-Strings jeweils mit eigenen Gleichstromwandlern auszurüsten. Die jeweiligen Gleichstromwandler speisen dann eine vorbestimmte Spannung in den Zwischenkreis des Leistungswandlers, beispielsweise über einen Spannungsbus.

Eine derartige Ausgestaltung ist beispielsweise aus DE 101 36 147 A1 bekannt.

Andererseits gibt es Systeme oder Installationen, in denen die Solarzellen-Strings im Hinblick auf ihren Typ, ihre Größe, ihre Ausrichtung, Abschattung und andere Faktoren so ähnlich sind, daß sie Ausgangsgrößen, beispielsweise Ausgangsspannungen, produzieren, die mehr oder weniger identisch sind. In diesem Fall kann es vorteilhaft sein, nicht nur die Gleichstromwandler an ihren Ausgängen parallel zu schalten, sondern auch die Eingänge der Gleichstromwandler.

Ein Gleichstromwandler hat üblicherweise zwei Eigenschaften, die in mancher Hinsicht nachteilig sind.

Zum einen gibt es eine obere Grenze für die Eingangsleistung, die nicht überschritten werden kann, ohne den Gleichstromwandler zu beschädigen. Zum anderen hat ein Gleichstromwandler vielfach einen verminderten Wirkungsgrad, wenn er mit niedriger Eingangsleistung arbeitet.

Wenn man nun die einzelnen Solarzellen-Strings (im folgenden werden diese auch kurz als "Solarzellen" bezeichnet) mit mehreren Gleichstromwandlern verbindet, dann kann man zum einen dafür sorgen, daß die elektrische Leistung gleichmäßig auf die Gleichstromwandler verteilt wird. Zum anderen kann man einzelne Gleichstromwandler abschalten, wenn die elektrische Eingangsleistung zu niedrig wird. Ein Gleichstromwandler hat nämlich einen gewissen Grundverbrauch auch dann, wenn er keine elektrische Leistung wandelt. Die Abschaltung erfolgt über eine Steuereinrichtung in Abhängigkeit von der zugeführten elektrischen Energie.

Die Steuereinrichtung muß nun "wissen", in welcher Konfiguration die einzelnen Gleichstromwandler in dem System angeordnet sind. Die Steuereinrichtung darf beispielsweise nur solche Gleichstromwandler abschalten, deren Solarzellen mit einem anderen Gleichstromwandler verbunden sind.

Die Information kann man der Steuereinrichtung durch eine manuelle Eingabe zur Verfügung stellen. Ein Monteur kann beispielsweise einen Schalter umlegen oder einen Parameter über eine Tastatur eingeben. Dabei besteht jedoch in erheblichem Maße die Gefahr einer Falscheingabe, insbesondere bei größeren Fotovoltaik-anlagen, bei der mehrere hundert Solarzellen-Strings vorhanden sind.

Wenn die Steuereinrichtung fehlerhaft mit Informationen versorgt worden ist, kann dies zu einer ineffizienten Verwendung der Solarzellen-Strings führen.

Der Erfindung liegt die Aufgabe zugrunde, die Zuverlässigkeit bei der Inbetriebnahme und im Betrieb eines Systems mit mehreren elektrischen Einrichtungen zu erhöhen.

Diese Aufgabe wird bei einem Verfahren der eingangs genannten Art dadurch gelöst, daß man eine Spannung an der Anschlußanordnung einer ersten Einrichtung verändert und die veränderte Spannung als erste Spannung bestimmt, daß man zumindest an der Anschlußanordnung einer zweiten Einrichtung eine zweite Spannung bestimmt und daß man anhand eines Vergleichs der Spannungen bestimmt, ob zwischen den Anschlußanordnungen der Einrichtungen eine elektrische Verbindung besteht oder nicht.

Mit dieser Vorgehensweise ist es möglich, in einem quasi automatisierten Verfahren zu bestimmen, ob die einzelnen elektrischen Einrichtungen mit ihren Anschlußanordnungen parallel geschaltet sind oder nicht. Bezogen auf die oben geschilderte Fotovoltaikanlage kann man also bestimmen, ob die einzelnen Solarzellen-Strings nur einzeln mit einem Gleichstromwandler verbunden sind oder ob mehrere Gleichstromwandler mit ihren Eingängen untereinander und mit den Solarzellen verbunden sind. Man macht sich dabei die Erkenntnis zunutze, daß die Veränderung einer Spannung an der Anschlußanordnung einer elektrischen Einrichtung eine entsprechende Veränderung der Spannung an der Anschlußanordnung einer anderen elektrischen Einrichtung mit sich bringt, wenn die beiden Anschlußanordnungen miteinander verbunden sind. Wenn eine Verbindung nicht besteht, dann wird eine Änderung an der Anschlußanordnung der ersten Einrichtung nicht zu einer entsprechenden Änderung der Spannung an der Anschlußanordnung der anderen Einrichtung führen. Dies gilt vor allem dann, wenn die Anschlußanordnungen direkt miteinander verbunden sind, also keine weiteren Baugruppen (abgesehen von Leitungen und Verbindern) zwischen den Anschlußanordnungen angeordnet sind.

Vorzugsweise wird die Spannung an der ersten Einrichtung verändert, indem man die erste Einrichtung belastet. Insbesondere bei Quellen erneuerbarer Energie, beispielsweise Solarzellen, gibt es einen gewissen Innenwiderstand. Die Spannung sinkt also bei Belastung von einer Leerlaufspannung auf eine Betriebsspannung. Wenn die Anschlußanordnungen von zwei Einrichtungen miteinander verbunden sind, dann wirkt sich die Belastung auf beide Einrichtungen aus, so daß die Spannungen an beiden Einrichtungen absinken werden. Wenn eine derartige Verbindung zwischen den Anschlußanordnungen hingegen nicht besteht, dann werden sich die Spannungen nicht entsprechend ändern.

Vorzugsweise wiederholt man die Bestimmung und verwendet als erste Einrichtung in aufeinanderfolgenden Bestimmungen eine andere Einrichtung. Man kann die Bestimmung beispielsweise bei jeder Inbetriebnahme wiederholen oder immer dann, wenn die Anlage oder das System anfängt, elektrische Leistung in ein übergeordnetes Netz einzuspeisen. Damit wird sichergestellt, daß eine Änderung der Konfiguration nicht übersehen werden kann, die möglicherweise in Betriebspausen erfolgt ist. Eine derartige Änderung kann auch ungewollt erfolgen. Dabei kann es von Vorteil sein, wenn man nicht immer die gleiche Einrichtung als erste Einrichtung verwendet, sondern man sozusagen durchwechselt.

Bevorzugterweise verwendet man als Anschlußanordnung eine Eingangs-Anschlußanordnung, die jeweils mit einer Energiequelle verbunden ist. Auf diese Weise verwendet man den Innenwiderstand der Energiequelle, um die Spannungsänderung zu bewirken.

Hierbei ist bevorzugt, daß man als Energiequelle eine Quelle erneuerbarer Energie verwendet. Eine derartige Quelle wird auch als regenerative Energiequelle oder Quelle regenerativer Energie bezeichnet. Bei einer derartigen Quelle stellt sich das Problem in besonderem Maße.

Alternativ dazu kann man als Anschlußanordnung auch eine Ausgangs-Anschlußanordnung verwenden. In diesem Fall wird beispielsweise der Innenwiderstand der elektrischen Einrichtung zur Änderung der Ausgangsspannung verwendet.

In einer bevorzugten Ausgestaltung ist vorgesehen, daß man dann, wenn man bei einer Bestimmung feststellt, daß die erste Einrichtung nicht mit einer anderen Einrichtung verbunden ist, eine andere Einrichtung als erste Einrichtung verwendet und sie in Bezug auf die verbleibenden Einrichtungen testet. Damit stellt man sicher, daß man auch unterschiedliche Verbindungsarten erfaßt. In einem System oder einer Anlage können durchaus mehrere Einrichtungen parallel geschaltet sein, während andere Einrichtungen isoliert betrieben werden. Dies kann man mit der vorgeschlagenen Vorgehensweise zuverlässig ermitteln.

Hierbei ist bevorzugt, daß man die Bestimmungen wiederholt und solange eine andere Einrichtung als erste Einrichtung verwendet, bis alle bis auf eine Einrichtung als erste Einrichtung verwendet worden sind. Man testet also sozusagen sämtliche Verbindungen durch, um festzustellen, ob irgendwo parallele Verbindungen existieren, d.h. die Anschlußanordnungen miteinander verbunden sind oder nicht.

In einer bevorzugten Ausgestaltung ist vorgesehen, daß man mehrere Einrichtungen, die ein gleichartiges Verhalten aufweisen und deren Anschlußanordnungen miteinander verbunden sind, gemeinsam als erste Einrichtung verwendet. In diesem Fall ist es bereits bekannt, daß diese Einrichtungen miteinander verbunden sind. Man kann dann eine Gruppe von Einrichtungen als "Master" verwenden und überprüfen, ob die verbleibenden Einrichtungen parallel mit dieser Gruppe geschaltet sind oder nicht.

Auch ist von Vorteil, wenn man bei einer Wechselspannung einen charakteristischen Wert ermittelt. Der charakteristische Wert ist ein Wert, der sich nicht mit der gleichen Frequenz ändert wie die Wechselspannung, beispielsweise der Effektivwert, eine gemittelte Scheitel-Scheitel-Spannung oder ein gleichgerichteter Mittelwert. Ein derartiger Wert läßt sich relativ leicht ermitteln. Er ist eine ausreichend aussagekräftige Größe, um die obengenannten Bestimmungen durchzuführen.

Die Erfindung wird bei einem System der eingangs genannten Art dadurch gelöst, daß an jeder Anschlußanordnung ein Sensor angeordnet ist, der mit der Steuereinrichtung verbunden ist, wobei die Steuereinrichtung Mittel, um die Spannung an jeder Anschlußanordnung zu verändern, einen Vergleicher, um Spannungen an verschiedenen Anschlußanordnungen miteinander zu vergleichen, und eine Speichereinrichtung aufweist, in der sie in Abhängigkeit vom Ausgangssignal des Vergleichers speichert, ob Anschlußanordnungen von elektrischen Einrichtungen miteinander verbunden sind oder nicht.

Die Steuereinrichtung führt also das oben beschriebene Verfahren aus und "merkt sich", welche elektrischen Einrichtungen miteinander verbunden sind und welche nicht. Dabei kann es durchaus vorkommen, daß es mehrere Gruppen von miteinander verbundenen elektrischen Einrichtungen gibt. Die Steuereinrichtung hat dann die Möglichkeit, in jeder Gruppe die einzelnen Einrichtungen so zu steuern, wie dies für eine optimale Betriebsweise günstig ist.

Vorzugsweise sind die elektrischen Einrichtungen als Gleichstromwandler ausgebildet. Die Steuereinrichtung kann dann, wenn die Gleichstromwandler miteinander verbunden sind, einzelne Gleichstromwandler abschalten, wenn die Eingangsleistung nicht ausreicht.

Bevorzugterweise sind die Ausgangs-Anschlußanordnungen der Gleichstromwandler parallel geschaltet. Die Gleichstromwandler haben also eine gemeinsame Ausgangsspannung.

Vorzugsweise sind die Ausgangs-Anschlußanordnungen mit einem Wechselrichter verbunden. Die Gleichstromwandler speisen also einen Zwischenkreis, aus dem der Wechselrichter die elektrische Leistung entnimmt.

In einer alternativen Ausgestaltung ist vorgesehen, daß die elektrischen Einrichtungen als Wechselrichter ausgebildet sind. Hier gilt im Grunde das Gleiche.

Dabei ist von Vorteil, wenn die Ausgangs-Anschluß-anordnungen der Wechselrichter parallel geschaltet sind. Auch dann läßt sich bei einem derartigen System feststellen, welche Wechselrichter an ihren Ausgängen parallel geschaltet sind und gemeinsam betrieben werden können und welche im individuellen Betrieb verwendet werden müssen.

Bevorzugterweise sind die Anschlußanordnungen als Eingangs-Anschlußanordnungen ausgebildet, die jeweils mit einer Quelle erneuerbarer Energie verbunden sind. Bei dieser Quelle kann es sich beispielsweise um Solarzellen-Strings, um Windkraftanlagen, um Wasserkraftanlagen, um Brennstoffzellen oder ähnliches handeln.

Die Erfindung wird im folgenden anhand von bevorzugten Ausführungsbeispielen in Verbindung mit der Zeichnung beschrieben. Hierin zeigen:
- Fig. 1: eine schematische Darstellung zur Erläuterung einer Anlage mit einem Solarzellen-String,
- Fig. 2: eine Anlage mit mehreren Solarzellen-Strings,
- Fig. 3: eine Anlage mit mehreren Solarzellen-Strings, von denen jeder einen eigenen Gleichstromwandler aufweist,
- Fig. 4: eine mögliche Verschaltung einer Anlage nach Fig. 3,
- Fig. 5: ein Flußdiagramm,
- Fig. 6: eine erste Beschaltung der Anlage nach Fig. 4,
- Fig. 7: eine zweite Beschaltung der Anlage nach Fig. 4,
- Fig. 8: eine dritte Beschaltung der Anlage nach Fig. 4,
- Fig. 9: eine abgewandelte Ausführungsform einer Anlage mit mehreren Solarzellen-Strings,
- Fig. 10: eine weitere Abwandlung einer Anlage im Ausschnitt,
- Fig. 11: eine Einrichtung zum Ändern der Spannung an einem Gleichspannungswandler und

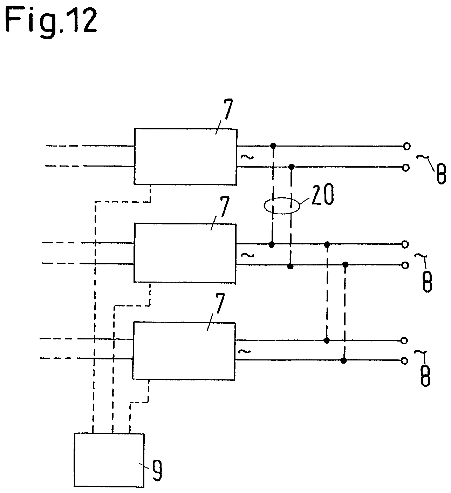

- Fig. 12: eine weitere Abwandlung einer Konfiguration im Ausschnitt.

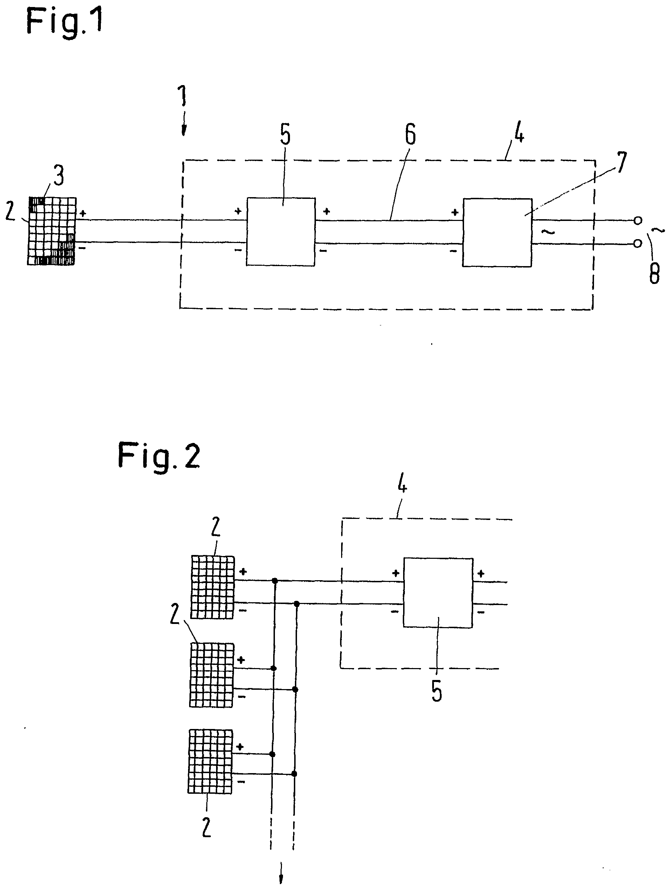

Fig. 1 zeigt in schematischer Darstellung ein System 1 zum Umwandeln von Sonnenenergie in elektrische Energie. Die Begriffe "System" und "Anlage" werden im folgenden synonym verwendet.

Das System 1 weist einen String 2 mit schematisch dargestellten Solarzellen 3 auf. Üblicherweise ist jeweils eine Vielzahl von Solarzellen 3 auf einem Paneel oder Tableau angeordnet. Mehrere derartiger Paneele bilden dann in Reihe den String 2. Am Ausgang des Strings 2 liefern die Solarzellen 3 eine Gleichspannung. Die Spannungsstärke variiert hierbei, beispielsweise in Abhängigkeit von der Sonneneinstrahlung, der Abschattung, der Umgebungstemperatur oder anderer Einflüsse.

Der String 2 ist mit einem Leistungswandler 4 verbunden, der auch als Leistungsumsetzer bezeichnet werden kann. Der Leistungswandler 4 weist zunächst einen Gleichstromwandler 5 auf. Der Gleichstromwandler 5 wandelt die veränderliche Gleichspannung, die vom String 2 geliefert wird, in eine konstante Gleichspannung um und gibt sie an einen Zwischenkreis 6 aus. Der Zwischenkreis 6 ist mit einem Wechselrichter 7 verbunden, der die Gleichspannung aus dem Zwischenkreis 6 in eine ein- oder mehrphasige Wechselspannung umwandelt und diese an ein Netz 8 ausgibt.

Wenn die Ausgangsleistung eines einzelnen Strings nicht ausreicht, dann kann man, wie in Fig. 2 dargestellt, mehrere Strings 2 verwenden. Die Ausgänge dieser Strings 2 werden miteinander verbunden. Die verbundenen Ausgänge werden mit dem Leistungswandler 4 verbunden, der auf gleiche Weise aufgebaut sein kann, wie in Fig. 1.

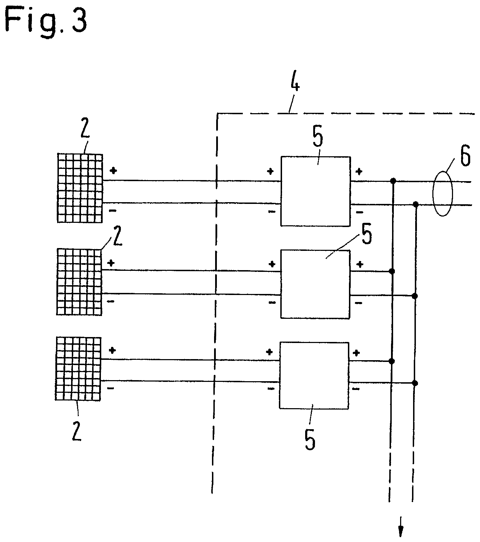

Eine Anordnung wie in Fig. 2 ist möglich, wenn die einzelnen Strings 2 an ihren Ausgängen ein gleichartiges Verhalten zeigen, insbesondere die gleiche Spannung abgeben. Davon ist jedoch nur dann auszugehen, wenn die Strings 2 und die Solarzellen 3 vom gleichen Typ sind, in gleicher Weise angeordnet sind, die gleiche Bestrahlung erfahren, auf gleiche Weise abgeschattet sind etc. In den meisten Fällen ist dies nicht der Fall. Es ist deswegen, wie in Fig. 3 dargestellt, vorteilhaft, den Leistungswandler 4 so aufzubauen, daß für jeden String 2 ein eigener Gleichstromwandler 5 vorhanden ist. Alle Gleichstromwandler 5 speisen dann in den Zwischenkreis 6. Eine derartige Ausgestaltung ist, wie oben erwähnt, beispielsweise aus DE 101 36 147 A1 bekannt.

Die Ausgestaltung nach Fig. 3 erfordert einerseits, daß jeder Gleichstromwandler 5 die Leistung verträgt, die von dem ihm zugeordneten String 2 geliefert wird. Wenn die gelieferte Leistung eine obere Grenze überschreitet, könnte dies zu einer Beschädigung oder sogar Zerstörung des Gleichstromwandlers führen. Andererseits haben die meisten Gleichstromwandler 5 bei einer niedrigen Leistung einen schlechten Wirkungsgrad. Sie verbrauchen elektrische Leistung, obwohl sie nur wenig oder gar keine Ausgangsleistung abgeben.

Aus diesem Grund wird vielfach bevorzugt, die einzelnen Strings 2 schon vor den Gleichstromwandlern 5 parallel zu schalten, also ihre Ausgänge miteinander zu verbinden, und die Gleichstromwandler 5 dann in den gemeinsamen Zwischenkreis 6 speisen zu lassen.

In diesem Fall ist eine Steuereinrichtung 9 erforderlich. Die Steuereinrichtung 9 steuert, wie dies mit gestrichelten Leitungsstrecken 10 angedeutet ist, die einzelnen Gleichstromwandler 5 bedarfsabhängig. Die Parallelschaltung der einzelnen Strings 2 ermöglicht es, die von den Strings 2 abgegebenen elektrischen Leistungen auf die Gleichstromwandler 5 zu verteilen, so daß eine Überlastung nicht zu befürchten ist. Andererseits kann die Steuereinrichtung 9 auch einzelne Gleichstromwandler einfach abschalten, wenn die von den Strings 2 gelieferte elektrische Leistung zu gering ist. In diesem Fall wird die Verlustleistung, die jeder Gleichstromwandler 5 benötigt, bei den abgeschalteten Gleichstromwandlern 5 eingespart.

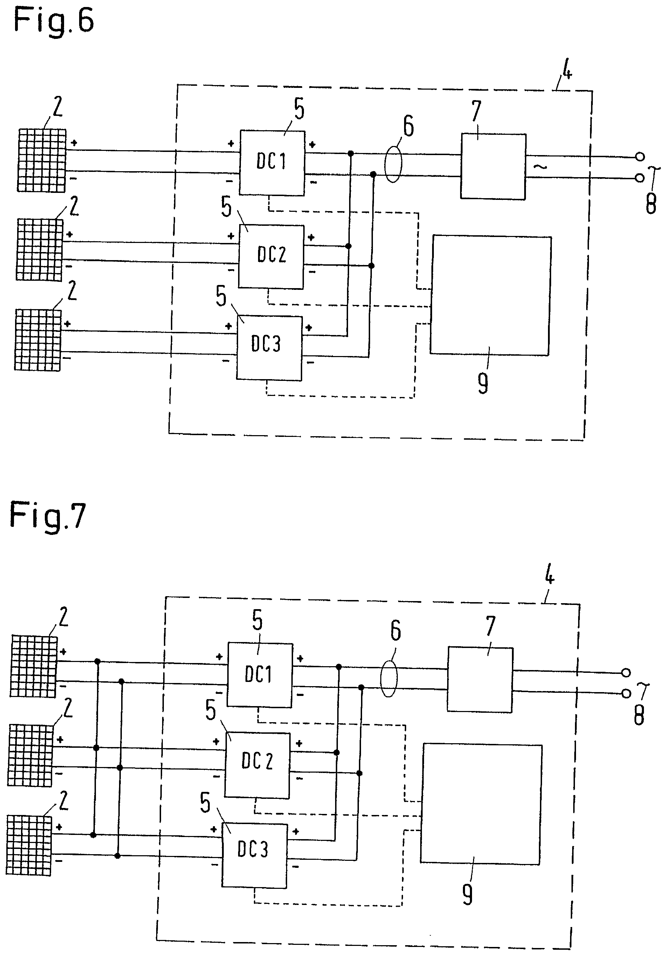

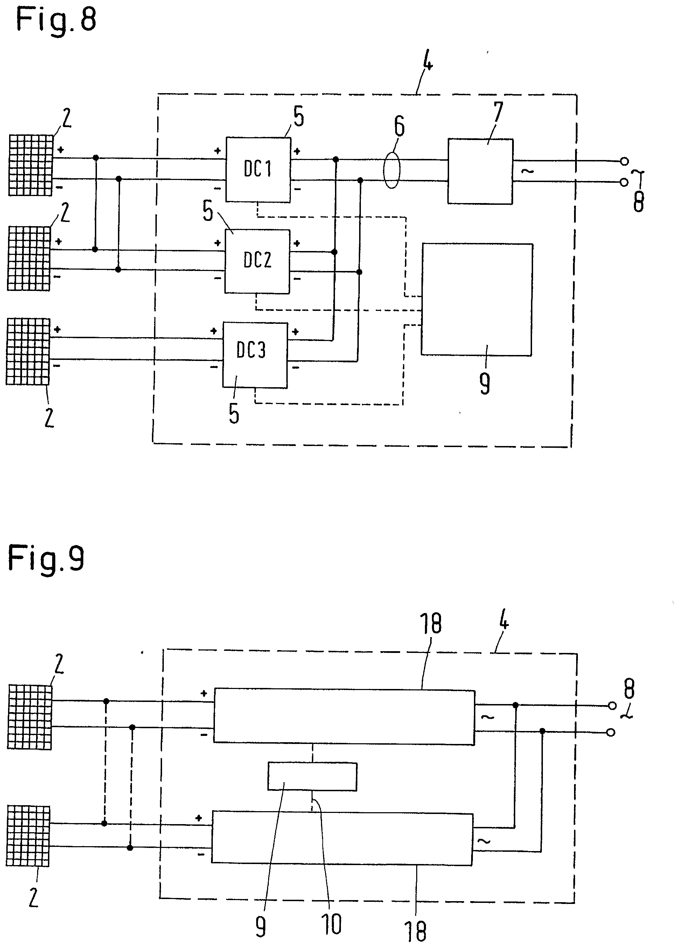

Bei der Montage einer Anlage kann es nun vorkommen, daß einzelne Verbindungen zwischen den Ausgängen von Strings 2 nicht ordnungsgemäß hergestellt werden oder mit Absicht weggelassen werden. Auch im Betrieb kann es vorkommen, daß eine derartige Verbindung unterbrochen wird, beispielsweise durch einen Sturm, einen Wasserschaden oder ein anderes natürliches Ereignis. Auch menschliche Eingriffe sind möglich. Drei unterschiedliche Konstellationen, die sich dann ergeben können, sind in den Fig. 6 bis 8 dargestellt. Diese werden weiter unten ausführlicher besprochen. In Fig. 6 sind beispielsweise die Strings 2 überhaupt nicht miteinander verbunden. In Fig. 7 sind alle Strings miteinander verbunden. In Fig. 8 sind nur zwei Strings 2 miteinander verbunden.

Damit die Steuereinrichtung 9 feststellen kann, in welcher Konfiguration die Strings 2 mit dem Leistungswandler 4 verbunden sind, ist an der Eingangs-Anschlußan-ordnung 11 eines jeden Gleichstromwandlers 5 ein Sensor 12 angeordnet, der mit der Steuereinrichtung 9 über strichpunktiert dargestellte Leitungsstrecken 13 verbunden ist. Die Leitungsstrecken 10, 13 können unterschiedliche Ausgestaltungen haben. Es kann sich um elektrische Leitungen handeln oder um optische Leitungen. Man kann die entsprechenden Strecken zwischen der Steuereinrichtung 9, den Gleichstromwandlern 5 und den Sensoren 12 auch leitungslos ausbilden und die entsprechende Signalübertragung dann über elektromagnetische Wellen, Licht, Schall oder ähnliches bewirken.

Der Sensor 12 an der Eingangs-Anschlußanordnung 11 des Gleichstromwandlers 5 ist hier als getrenntes Element ausgebildet. Es versteht sich aber, daß die Steuereinrichtung 9 die entsprechende Information auch im Gleichstromwandler 5 unmittelbar erfahren kann, beispielsweise über eine Spannungsmessung an der Eingangs-Anschlußanordnung 11.

Damit die Steuereinrichtung 9 nun feststellen kann, in welcher Konfiguration die Strings 2 mit dem Leistungswandler 4 verbunden sind, führt sie zumindest nach der Inbetriebnahme, vorzugsweise aber öfters, beispielsweise nach jeder leistungsfreien Periode oder in regelmäßigen Abständen, einen Algorithmus durch, der sich kurz wie folgt beschreiben läßt:

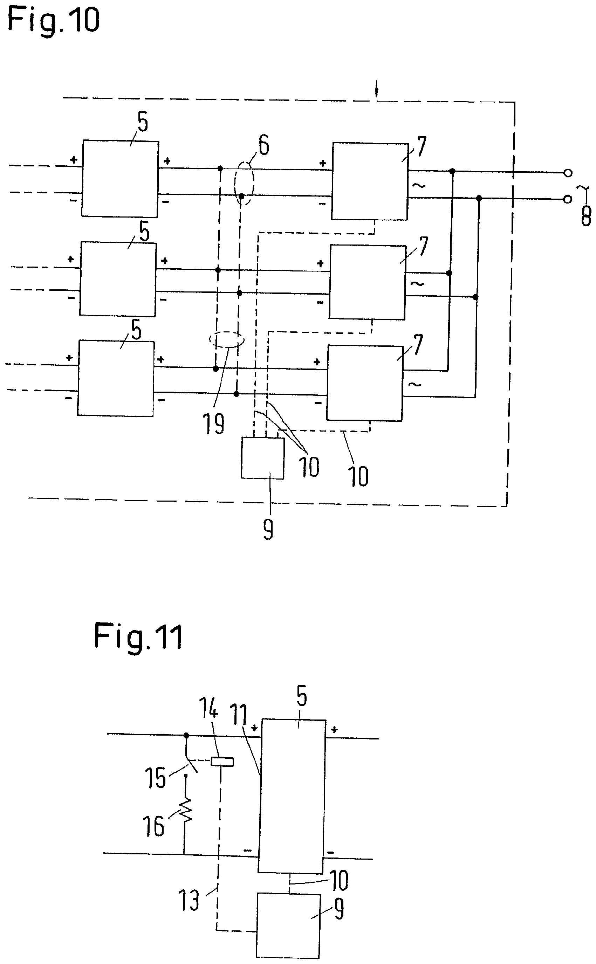

Die Steuereinrichtung 9 wählt einen ersten Gleichstromwandler 5 aus und senkt die Spannung dort ab. Dies erfolgt vorzugsweise dadurch, daß die Steuereinrichtung den Gleichstromwandler so steuert, daß er elektrische Energie in den Zwischenkreis 6 liefert. Ein anderes Mittel hierzu ist schematisch in Fig. 11 dargestellt. Die Steuereinrichtung 9 betätigt einen Elektromagneten 14, der einen Schalter 15 schließt. Mit dem Schließen des Schalters wird parallel zur Eingangs-Anschlußanord-nung ein Widerstand 16 gelegt, so daß über den Widerstand 16 ein Strom fließt. Da der String 2 einen Innenwiderstand aufweist, führt dies zu einem Absinken der Spannung an der Eingangs-Anschlußanordnung 11. An den Eingangs-Anschlußanordnungen 11 der anderen Gleichstromwandler 5 wird hingegen keine Leistung entnommen. Die Spannung an den Eingangs-Anschlußanordnungen 11 der anderen Gleichstromwandler 5 wird gemessen. Wenn die gemessene Spannung an einem bestimmten Eingang sich auf gleiche Weise ändert wie die Spannung am Eingang des ersten Gleichstromwandlers, dann kann man daraus schließen, daß die Ausgänge der Strings 2 mit den Eingangs-Anschlußanordnungen 11 der infrage stehenden Gleichstromwandler 5 verbunden sind, mit anderen Worten: parallel geschaltet sind. Wenn sich die Spannungen nicht entsprechend ändern, dann ist dies nicht der Fall. Die Steuereinrichtung 9 stellt dies fest und vermerkt dann in einem nur schematisch dargestellten Speicher 17, daß für die Zukunft, d.h. bis zur nächsten Überprüfung, die Strings 2 parallel geschaltet sind oder nicht.

Die Steuereinrichtung 9 wählt also einen Gleichstromwandler 5 als "Master". Die verbleibenden Gleichstromwandler 5 werden als "Slave" behandelt. Der Master wird in Betrieb genommen, indem an seinem Eingang Leistung entnommen wird. Die Slaves werden in einen Zustand versetzt, wo eine derartige Leistungsentnahme nicht stattfindet. Am Master wird die Spannung von einer Leerlaufspannung, also die Leerlaufspannung des mit dem Master verbundenen Strings 2, absinken, da der String 2 einen Innenwiderstand hat. Die an der Eingangs-Anschlußanord-nung 11 entnommene Leistung wird so lange gesteigert, bis die Eingangsspannung am Master bis auf einen vorbestimmten Anteil der Leerlaufspannung abgefallen ist. Nach einer vorbestimmten Zeit wird die Spannungsdifferenz zwischen dem Master und jedem Slave berechnet oder auf andere Weise bestimmt. Wenn bei einer Ausgangsspannung von beispielsweise 80 V eines Strings 2 die Unterschiede größer als 15 V sind, dann kann man annehmen, daß es keine parallele Verbindung der Strings 2 zu den Gleichstromwandlern 5 gibt. Wenn der Unterschied kleiner als 10 V ist, kann man annehmen, daß es eine parallele Verbindung zwischen den Eingängen des Masters und des Slave gibt.

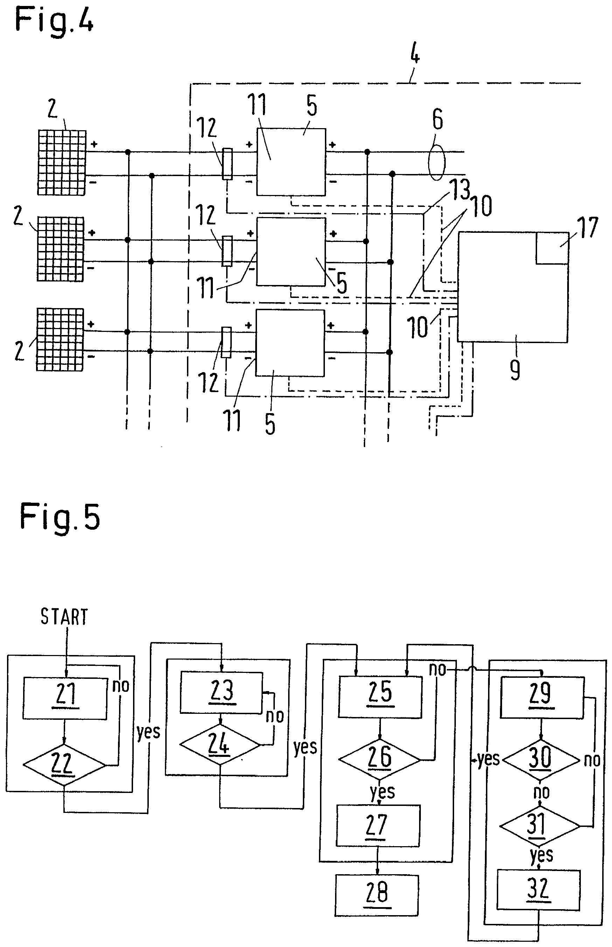

Ein entsprechender Algorithmus ist schematisch in Fig. 5 dargestellt. In einem Schritt 21 wartet man, ob mindestens zwei Gleichstromwandler 5 sich als bereit gemeldet haben. Dies ist beispielsweise dann der Fall, wenn an ihrer Eingangs-Anschlußanordnung 11 eine ausreichende Gleichspannung ansteht. In der Entscheidung 22 wird geprüft, ob sich zwei Gleichstromwandler 5 als bereit gemeldet haben. Wenn dies nicht der Fall ist, wartet man weiter. Wenn man zwei bereite Gleichstromwandler 5 hat, werden sie in einem Schritt 23 kalibriert. Dazu werden alle Gleichstromwandler 5 abgeschaltet. Die Steuereinrichtung 9 zeichnet die gemessenen Spannungsdifferenzen zwischen den einzelnen Gleichstromwandlern 5 auf. Damit kann man beispielsweise Offsets kompensieren, die es in den gemessenen Spannungen eines jeden einzelnen Gleichstromwandlers 5 geben kann. Wenn der Schritt des Kalibrierens erfolgreich vorgenommen worden ist (Entscheidung 24), wird in einem Schritt 25 untersucht, ob alle Module, also alle Gleichstromwandler 5, getestet worden sind. Wenn nur noch ein Gleichstromwandler 5 ungetestet worden ist, wird dieser Gleichstromwandler 5 im Speicher 17 als "individual mode" vermerkt, d.h. die Steuereinrichtung 9 hat dann festgestellt, daß dieser Gleichstromwandler 5 mit keinem anderen Gleichstromwandler 5 eingangsmäßig parallel geschaltet worden ist. Wenn die Entscheidung 26 bejaht wird, dann werden in einem Schritt 27 alle Fehler, die möglicherweise aufgetreten sind, ausgegeben. Im übrigen wird das Verfahren beendet (Schritt 28).

Wenn es noch ungetestete Gleichstromwandler 5 gibt, wird der nächste Gleichstromwandler 5 in einem Schritt 29 getestet. Wurde dieser Test unterbrochen (Entschei-dung 30), kehrt man zum Schritt 25 zurück. In einer Entscheidung 31 wird überprüft, ob der Test bis zum Ende durchgeführt worden ist. Wenn dies der Fall ist, wird in einem Schritt 32 für jeden Gleichstromwandler 5 der Betriebsmodus festgelegt, also individueller Betrieb oder Betrieb in Parallelschaltung mit anderen Gleichstromwandlern 5.

Dies soll nachfolgend anhand der Fig. 6 bis 8 näher erläutert werden. Hier sind die Sensoren 12 und die zugehörigen Leitungsstrecken 13 aus Gründen der Übersicht nicht mehr eingezeichnet.

In Fig. 6 sind die Strings 2 jeweils nur mit ihren Gleichstromwandlern 5 verbunden. Diese sind zur leichteren Unterscheidung mit DC1, DC2 und DC3 bezeichnet.

Wenn der Leistungswandler 4 mit dem Netz 8 verbunden wird, wird die Kalibrierung durchgeführt, während der alle Gleichstromwandler 5 ausgeschaltet sind.

Danach wird DC1 eingeschaltet, um Energie zu liefern, während DC2 und DC3 ausgeschaltet bleiben. Nach einer vorbestimmten Zeit, beispielsweise 45 Sekunden, weiß die Steuereinrichtung 9, daß DC1 nicht parallel mit DC2 oder DC3 geschaltet ist. Deswegen darf DC1 weiter Energie erzeugen. Die Speichereinrichtung 9 merkt sich, daß DC1 einzeln angeordnet ist.

Danach wird DC2 eingeschaltet und liefert Energie. DC3 bleibt ausgeschaltet. Nach einer vorbestimmten Zeit weiß die Steuereinrichtung 9, daß DC2 und DC3 nicht parallel geschaltet sind, weil sich am Eingang von DC3 keine Spannungsänderung ergeben hat. DC2 darf weiter Energie erzeugen (d.h. liefern) in der individuellen Betriebsweise.

Da DC3 der letzte ungetestete Gleichstromwandler 5 ist, kann er nicht parallel mit irgendeinem anderen Gleichstromwandler 5 geschaltet sein. Aus diesem Grund merkt sich die Steuereinrichtung 9, daß DC3 ebenfalls in der individuellen Betriebsweise betrieben wird und DC3 kann weiter Energie erzeugen. Mit "Energie erzeugen" ist hier gemeint, daß die Gleichstromwandler 5 den Strom von den Strings 2 der Solarzellen 3 in den Zwischenkreis 3 einspeisen.

Fig. 7 zeigt ein Beispiel, bei dem drei Strings 2 parallel geschaltet sind. In diesem Fall läuft das Verfahren wie folgt ab:
Der Leistungswandler 4 wird mit dem Netz 8 verbunden. Die Kalibrierung wird durchgeführt, während alle Gleichstromwandler 5 ausgeschaltet sind. Der Gleichstromwandler DC1 wird eingeschaltet, d.h. an seinem Eingang belastet. Die beiden Gleichstromwandler DC2 und DC3 bleiben ausgeschaltet. Nach einer vorbestimmten Zeit weiß die Steuereinrichtung 9, daß DC1 parallel mit DC2 und DC3 ist. Alle drei Gleichstromwandler 5 werden also als parallel geschaltet vermerkt. Da kein ungetesteter Gleichstromwandler 5 verbleibt, ist der Test ausgeführt.

In Fig. 8 sind lediglich zwei Strings 2 parallel miteinander geschaltet. Der dritte String ist nur mit dem Gleichstromwandler DC3 verbunden. Die fehlende Verbindung kann bei der Montage vergessen worden sein. Es ist auch möglich, daß sie durch einen Sturm oder ähnliches beschädigt worden ist. In diesem Fall läuft der Test wie folgt ab:
Der Leistungswandler 4 wird mit dem Netz 8 verbunden. Die Kalibrierung wird durchgeführt, während alle Gleichstromwandler 5 ausgeschaltet sind.

DC1 wird eingeschaltet, während DC2 und DC3 ausgeschaltet sind. Nach einer vorbestimmten Zeit wird das System wissen, daß DC1 parallel mit DC2 geschaltet ist. DC1 und DC2 werden als parallel geschaltet gespeichert.
Da DC3 der letzte ungetestete Gleichstromwandler 5 ist, kann er nicht parallel mit irgendeinem anderen Gleichstromwandler 5 geschaltet sein. DC3 wird dann als individueller Gleichstromwandler betrieben. Da keine ungetesteten Gleichstromwandler 5 verbleiben, ist der Test ausgeführt.

Die Spannung, auf die der Eingang des Masters abgesenkt wird, hängt von den Eigenschaften der Leistungsquelle, im vorliegenden Fall der Strings 2 ab. Darüber hinaus kann auch die Empfindlichkeit der Spannungsmessungstechnik eine Rolle spielen, die Genauigkeit der Spannungsmessung und ähnliche Faktoren. Wenn man beispielsweise einen 3 kW-Wandler verwendet, der mit einem String 2 aus Solarzellen betrieben wird, dann ist beispielsweise eine Spannung von 80 % der Leerlaufspannung geeignet.

Die vorbestimmte Zeit, die man verstreichen läßt, um einen stabilen Zustand zu erzeugen, d.h. um zu überprüfen, ob die Spannungen sich gleich oder unterschiedlich entwickelt haben, hängen von den transienten Eigenschaften des Systems ab. In dem obengenannten Beispiel eines 3 kW-Wandlers kann man beispielsweise eine Periode von 45 Sekunden als ausreichend für die Stabilisierung der Spannung ansehen.

Wie oben bereits ausgeführt, steht die Steuereinrichtung 9 mit den Gleichstromwandlern 5 über Leitungsstrecken in Verbindungen. Sie können analog oder digital ausgeführt sein, als Bussystem oder drahtlos. Auch die Signale der Sensoren 12 können entsprechend übertragen werden.

Die Steuereinrichtung 9 muß nicht physikalisch von den Gleichstromwandlern 5 getrennt sein. Sie könnte beispielsweise mit einem der Wandler zusammengebaut sein und von dort die übrigen Gleichstromwandler 5 steuern mit Hilfe von den oben beschriebenen Leitungsstrecken.

Die Steuereinrichtung 9 kann in einer vorteilhaften Ausgestaltung jedesmal mit einem anderen Gleichstromwandler 5 starten, d.h. beim ersten Test mit DC1, beim zweiten Test mit DC2, beim dritten Test mit DC3 und beim vierten Test wieder mit DC1. Damit kann man Fehler ausmitteln.

Die Vorgehensweise funktioniert auch dann, wenn zwei oder mehr Gleichstromwandler mit ihren verbundenen Strings 2 von Gleichstromzellen 3 als Mastereinheit arbeiten. In diesem Fall stellt die Steuereinrichtung sicher, daß die Last in einer bestimmten Art auf die Gleichstromwandler 5 verteilt wird. In diesem Fall würde man bestimmen, ob der Eingang eines Gleichstromwandlers 5, der nicht zu dieser Mastereinheit gehört, parallel zu dem Eingang irgendeines Gleichstromwandlers 5 geschaltet ist, der zu der Mastereinheit gehört.

Man kann auch eine Mehrzahl von Steuereinrichtungen 9 verwenden, beispielsweise eine in jedem Gleichstromwandler 5. Diese unterschiedlichen Steuereinrichtungen 9 können dann zusammenarbeiten, um zu entscheiden, welcher Gleichstromwandler 5 als Master und welcher als Slave arbeiten soll.

Die Vorgehensweise kann auch verwendet werden, wenn der Leistungswandler 4 Einheiten 18 verwendet, die die Leistung aus den Strings 2 unmittelbar in das Netz 8 speisen, d.h. ohne einen herausgeführten Gleichspannungszwischenkreis 6.

Die Vorgehensweise kann man auch verwenden in einem System, das eine Vielzahl von Wechselrichtern 7 aufweist, wie dies beispielsweise in Fig. 10 dargestellt ist. Mit gestrichelten Linien 19 sind hier mögliche Verbindungen zur eingangsmäßigen Parallelschaltung der Wechselrichter 7 dargestellt. Die Eingänge, die oben beschrieben sind, sind in diesem Fall die Eingänge der Wechselrichter aus dem Zwischenkreis 6. Die Steuereinrichtung 9 steuert in diesem Fall die Wechselrichter 7, d.h. sie schaltet sie an oder aus, wie erforderlich, um die erforderlichen Leistungszustände herzustellen.

Die oben beschriebene Vorgehensweise kann man auch dann verwenden, wenn die Ausgänge der Wechselrichter 7 parallel geschaltet sind. Mit gestrichelten Linien 20 sind mögliche Verbindungen dargestellt. Man erzeugt in diesem Fall eine Leistung an einem Ausgang und mißt, ob die sich ergebende Spannung an anderen Ausgängen erfaßbar ist. Der Vorteil einer derartigen Vorgehensweise besteht darin, daß man eine oder mehrere Ausgangsstufen, d.h. einen oder mehrere Wechselrichter 7 abschalten kann, um Leistung zu sparen, wenn die Eingangsleistung zu gering ist.

Es wurde oben beschrieben, daß die Spannung abgesenkt wurde, um festzustellen, ob Einheiten parallel geschaltet sind oder nicht. Natürlich kann man auch die Spannung anheben.

Die Vorgehensweise funktioniert sowohl bei Gleichspannung als auch bei Wechselspannung. Bei Wechselspannung reicht es aus, den Effektivwert zu ermitteln oder einen anderen Wert, der sich langsamer ändert als mit der Frequenz der Wechselspannung, beispielsweise eine Scheitelspannung, ggf. gemittelt, ein Mittelwert einer gleichgerichteten Spannung oder dergleichen.

## Patentansprüche

1. Verfahren zum Bestimmen einer Zusammenschaltungsart von mindestens zwei elektrischen Einrichtungen, von denen jede eine gleichartige Anschlußanordnung aufweist, welche jeweils mit mindestens einer Solarzellen aufweisenden Energiequelle verbunden ist, **dadurch gekennzeichnet, dass** man eine Spannung an der Anschlußanordnung einer ersten Einrichtung verändert, indem man die mit der ersten Einrichtung verbundene Energiequelle durch die erste Einrichtung belastet, und die Änderung der Spannung als erste Spannungsänderung bestimmt, und zumindest an der Anschlußanordnung einer zweiten Einrichtung eine zweite Spannungsänderung als Folge der Belastung bestimmt und wobei man anhand eines Vergleichs der Spannungsänderungen bestimmt, ob zwischen den Anschlußanordnungen der Einrichtungen eine elektrische Verbindung besteht oder nicht.

2. Verfahren nach Anspruch 1, wobei man die Bestimmung wiederholt und als erste Einrichtung in aufeinanderfolgenden Bestimmungen eine andere Einrichtung verwendet.

3. Verfahren nach Anspruch 1 oder 2, wobei man als Anschlußanordnung eine Eingangs-Anschlußanordnung verwendet.

4. Verfahren nach einem der Ansprüche 1 bis 3, wobei eine der zwei Einrichtungen bei geringer Leistung nur dann abgeschaltet wird, wenn eine elektrische Verbindung zwischen den Anschlußanordnungen der Einrichtungen besteht.

5. Verfahren nach einem der Ansprüche 1 bis 2, wobei man als Anschlußanordnung eine Ausgangs-Anschlußanordnung verwendet.

6. Verfahren nach einem der Ansprüche 1 bis 5, wobei man dann, wenn man bei einer Bestimmung feststellt, daß die erste Einrichtung nicht mit einer anderen Einrichtung elektrisch verbunden ist, eine andere Einrichtung als erste Einrichtung verwendet und sie in Bezug auf die verbleibenden Einrichtungen testet.

7. Verfahren nach Anspruch 6, wobei man die Bestimmungen wiederholt und solange eine andere Einrichtung als erste Einrichtung verwendet, bis alle bis auf eine Einrichtung als erste Einrichtung verwendet worden sind.

8. Verfahren nach einem der Ansprüche 1 bis 7, wobei man mehrere Einrichtungen, die ein gleichartiges Verhalten aufweisen und deren Anschlußanordnungen miteinander verbunden sind, gemeinsam als erste Einrichtung verwendet.

9. Verfahren nach einem der Ansprüche 1 bis 8, wobei man bei einer Wechselspannung einen charakteristischen Wert ermittelt.

10. System mit mehreren elektrischen Einrichtungen (5), von denen jede eine gleichartige Anschlußanordnung (11) aufweist, und einer Steuereinrichtung (9), wobei an jeder der Anschlußanordnungen jeweils ein Solarzellen-String angeschlossen ist, **dadurch gekennzeichnet, dass** an jeder Anschlußanordnung (11) ein Sensor (12) angeordnet ist, der mit der Steuereinrichtung (9) verbunden ist, wobei die Steuereinrichtung (9) Mittel, um die Spannung an jeder Anschlußanordnung (11) durch Belastung der Solarzellen zu verändern, einen Vergleicher, um Spannungsänderungen, die Folge der oben genannten Belastung sind an verschiedenen Anschlußanordnungen (11) miteinander zu vergleichen, und eine Speichereinrichtung (17) aufweist, in der sie in Abhängigkeit vom Ausgangssignal des Vergleichers speichert, ob Anschlußanordnungen (11) von elektrischen Einrichtungen (5) miteinander verbunden sind oder nicht.

11. System nach Anspruch 10, wobei die elektrischen Einrichtungen (5) als Gleichstromwandler ausgebildet sind.

12. System nach Anspruch 11, wobei die Ausgangs-Anschlußanordnungen der Gleichstromwandler (5) parallel geschaltet sind.

13. System nach Anspruch 12, wobei die Ausgangs-Anschlußanordnungen mit einem Wechselrichter (7) verbunden sind.

14. System nach Anspruch 10, wobei die elektrischen Einrichtungen (5) als Wechselrichter ausgebildet sind.

15. System nach Anspruch 14, wobei die Ausgangs-Anschlußanordnungen der Wechselrichter parallel geschaltet sind.

16. System nach einem der Ansprüche 10 bis 15, wobei die Anschlußanordnungen (11) als Eingangs-Anschlußanordnungen ausgebildet sind, die jeweils mit einer Quelle (2) erneuerbarer Energie verbunden sind.

## Claims

1. A method for determining a type of interconnection of at least two electrical devices, each comprising a similar terminal arrangement being connected in each case to at least one energy source comprising solar cells, **characterized in that** a voltage at the terminal arrangement of a first device is changed by loading the energy source connected to the first device by the first device, the change in voltage being determined as the first voltage change, and a second voltage change is determined at least at the terminal arrangement of a second device as a result of the loading, and wherein it is determined by comparing the voltage changes whether or not an electrical connection exists between the terminal arrangements of the devices.

2. The method according to claim 1, wherein the determination is repeated and another device is used as the first device in successive determinations.

3. The method according to claim 1 or 2, wherein an input terminal arrangement is used as the terminal arrangement.

4. The method according to any one of claims 1 to 3, wherein one of the two devices is deactivated at low power only if there is an electrical connection between the terminal arrangements of the devices.

5. The method according to any one of claims 1 to 2, wherein an output terminal arrangement is used as the terminal arrangement.

6. The method according to any one of claims 1 to 5, wherein a device different to the first device is used and tested relative to the remaining devices, when a determination results in that the first device is not electrically connected to any other device.

7. The method according to claim 6, wherein the deteminations are repeated and another device is used as the first device until all but one device have been used as the first device.

8. The method according to any one of claims 1 to 7, wherein several devices having similar behaviour and whose terminal arrangements are interconnected are jointly used as the first device.

9. The method according to any one of claims 1 to 8, a characteristic value being determined for an alternating voltage.

10. A system with a plurality of electrical devices (5), each comprising a similar terminal arrangement (11), and a control device (9), wherein at least one solar cell string is connected to each of the terminal arrangements, **characterized in that** a sensor (12) connected to the control device (9) is arranged on each terminal arrangement (11), the control device (9) comprising means for changing the voltage at each terminal arrangement (11) by loading the solar cells, a comparator for comparing voltage changes resulting from the above loading to voltages at different terminal arrangements (11), and a memory device (17) storing whether or not terminal arrangements (11) of electrical devices (5) are connected to each other depending on the output signal of the comparator.

11. The system according to claim 10, wherein the electrical means (5) is provided as a DC-DC converter.

12. The system according to claim 11, wherein the output terminal arrangements of the DC-DC converters (5) are connected in parallel.

13. The system according to claim 12, wherein the output terminal arrangements are connected to an inverter (7).

14. The system according to claim 10, wherein the electrical devices (5) are provided as inverters.

15. The system according to claim 14, wherein the output terminal arrangements of the inverters are connected in parallel.

16. The system according to any one of claims 10 to 15, wherein the terminal arrangements (11) are provided as input terminal arrangements, each connected to a source (2) of renewable energy.

## Revendications

1. Procédé de détermination d'un mode d'interconnexion d'au moins deux dispositifs électriques, dont chacun possède un arrangement de raccordement identique, lequel est respectivement relié à une source d'énergie qui possède au moins une cellule solaire, **caractérisé en ce qu'**une tension au niveau de l'arrangement de raccordement d'un premier dispositif est modifiée en mettant en charge la source d'énergie reliée au premier dispositif avec le premier dispositif, et la modification de la tension est déterminée en tant que première variation de tension, et une deuxième variation de tension est déterminée au moins au niveau de l'arrangement de raccordement d'un deuxième dispositif en conséquence de la mise en charge et une comparaison des variations de tension servant à déterminer s'il existe ou non une liaison électrique entre les arrangements de raccordement des dispositifs.

2. Procédé selon la revendication 1, la détermination étant répétée et un autre dispositif étant utilisé en tant que premier dispositif dans les déterminations successives.

3. Procédé selon la revendication 1 ou 2, un arrangement de raccordement d'entrée étant utilisé comme arrangement de raccordement.

4. Procédé selon l'une des revendications 1 à 3, l'un des deux dispositifs n'étant mis hors tension à faible puissance que s'il existe une liaison électrique entre les arrangements de raccordement des dispositifs.

5. Procédé selon l'une des revendications 1 à 2, l'arrangement de raccordement utilisé étant un arrangement de raccordement de sortie.

6. Procédé selon l'une des revendications 1 à 5, selon lequel, si une détermination amène à constater que le premier dispositif n'est pas relié électriquement à un autre dispositif, un autre dispositif est alors utilisé comme premier dispositif et celui-ci est alors testé en référence aux dispositifs restants.

7. Procédé selon la revendication 6, les déterminations étant répétées et un autre dispositif étant utilisé comme premier dispositif jusqu'à ce que tous les dispositifs, sauf un, ont été utilisés en tant que premier dispositif.

8. Procédé selon l'une des revendications 1 à 7, plusieurs dispositifs qui possèdent un comportement identique et dont les arrangements de raccordement sont reliés entre eux étant utilisés en commun en tant que premier dispositif.

9. Procédé selon l'une des revendications 1 à 8, une valeur caractéristique étant déterminée en présence d'une tension alternative.

10. Système comprenant plusieurs dispositifs électriques (5), dont chacun possède un arrangement de raccordement (11) identique, et un dispositif de commande (9), une chaîne de cellules solaires étant respectivement raccordée à chacun des arrangements de raccordement, **caractérisé en ce qu'**un capteur (12) est disposé au niveau de chaque arrangement de raccordement (11), lequel est relié au dispositif de commande (9), le dispositif de commande (9) possédant des moyens pour modifier la tension au niveau de chaque arrangement de raccordement (11) par mise en charge des cellules solaires, un comparateur pour comparer entre elles les variations de tension qui sont la conséquence de la mise en charge susmentionnée au niveau des différents arrangements de raccordement (11), et un dispositif de mémorisation (17) dans lequel il enregistre, en fonction du signal de sortie du comparateur, si les arrangements de raccordement (11) des dispositifs électriques (5) sont reliés entre eux ou non.

11. Système selon la revendication 10, les dispositifs électriques (5) étant réalisés sous la forme de convertisseurs de tension continue.

12. Système selon la revendication 11, les arrangements de raccordement de sortie des convertisseurs de tension continue (5) étant branchés en parallèle.

13. Système selon la revendication 12, les arrangements de raccordement de sortie étant reliés à un onduleur (7).

14. Système selon la revendication 10, les dispositifs électriques (5) étant réalisés sous la forme d'onduleurs.

15. Système selon la revendication 14, les arrangements de raccordement de sortie des onduleurs étant branchés en parallèle.

16. Système selon l'une des revendications 10 à 15, les arrangements de raccordement (11) étant réalisés sous la forme d'arrangements de raccordement d'entrée qui sont respectivement reliés à une source (2) d'énergie renouvelable.
